# FASCICULE DE BREVET EUROPEEN

(11) **EP 2 408 286 B1**
(45) Date de publication et mention de la délivrance du brevet: **07.06.2017**
(21) Numéro de dépôt: 10169448.7
(22) Date de dépôt: 13.07.2010
(51) Int. Cl.: H05K 5/02

(54) **Dispositif de detection de l'ouverture d'une trappe dans un equipement comprenant une ou plusieurs cartes electroniques**
Vorrichtung zum Detektieren der Öffnung eines Abschlussdeckels in einer Anlage, die eine oder mehrere elektronische Leiterplatten enthält
Device for detecting the opening of a lid in an equipment including one or more electronic boards

(43) Date de publication de la demande: 18.01.2012
(73) Titulaire: Thales, 92400 Courbevoie (FR)
(72) Inventeur: Marron, Christophe, 49300, CHOLET (FR); Abadie, Marc, 49300, CHOLET (FR); Gribovalle, David, 44230, SAINT SEBASTIEN SUR LOIRE (FR); Borrat-Michaud, Pierre, 49100, ANGERS (FR)
(74) Mandataire: Lucas, Laurent Jacques

(56) Documents cités:
- EP-A1- 1 054 316
- EP-A1- 1 282 348
- DE-A1-102007 057 948
- US-A1- 2008 148 074

## Description

La présente invention concerne un dispositif de détection de l'ouverture d'une trappe dans un équipement comprenant une ou plusieurs cartes électroniques. Elle s'applique notamment à la sécurisation de boîtiers comprenant une trappe d'accès placée orthogonalement aux cartes contenues dans le boîtier.

Les équipements électroniques sont généralement pourvus d'un accès sous forme d'une trappe ou d'un capot amovible afin de pouvoir intervenir sur les cartes et/ou circuits de l'équipement, notamment lors d'une réparation ou d'un contrôle. Néanmoins, l'ouverture d'une telle trappe est, en général, réservée à des situations bien particulières et ne doit pas pouvoir être effectuée de manière intempestive ou par une personne non autorisée. Aussi, des dispositifs connus permettent de détecter l'ouverture inopportune d'une trappe puis de lever une alerte ou de neutraliser l'équipement lorsqu'une telle ouverture se produit. Classiquement, deux techniques sont adoptées.

Une première technique consiste en l'utilisation d'un commutateur électromécanique fixé sur une carte électronique située à l'intérieur de l'équipement. Un téton solidaire de la trappe vient enfoncer le commutateur lors de la mise en place de la trappe, puis le commutateur est relâché avec le retrait de la trappe. Cette solution est bien adaptée à la détection d'ouverture d'une trappe parallèle au plan des cartes électroniques. Toutefois, lorsque le plan de la trappe est orthogonal aux plans des cartes électroniques contenues dans l'équipement, il est nécessaire d'employer un commutateur de grandes dimensions, impossible à loger dans un espace réduit. On peut par exemple citer la demande de brevet américain publiée sous le numéro US2008/148074, qui divulgue un équipement pourvu d'une carte électronique disposée dans un boîtier fermé par une trappe et de moyens de détection de l'ouverture de cette trappe pour couper l'alimentation de la carte électronique. Ces moyens comprennent un élément venant en contact, par pression de la trappe lorsque celle-ci est fermée, d'un élément de détection présent sur la carte. Si la trappe est ouverte, l'élément souple est désolidarisé de l'élément de détection et un signal est transmis à la carte via des contacts afin de couper son alimentation électrique. Toutefois, ce dispositif requiert un espace relativement important.

Selon une deuxième technique connue, des espaces conducteurs sont réservés sur une carte électronique et la trappe comporte un élément mettant en court-circuit ces deux espaces lors de sa mise en place. Cette deuxième technique est applicable lorsque les cartes électroniques sont parallèles à la trappe mais ne convient pas à une configuration dans laquelle la trappe est orthogonale aux cartes.

Un but de l'invention est de proposer une solution pour détecter l'ouverture d'une trappe dans un équipement comprenant des cartes électroniques orthogonales à ladite trappe, en particulier lorsque l'espace disponible pour effectuer cette détection est très réduit, de l'ordre par exemple de quelques mm². A cet effet, l'invention a pour objet un dispositif de détection de l'ouverture d'une trappe fermant un boîtier dans un équipement comportant une ou plusieurs cartes électroniques dont les plans sont sensiblement orthogonaux au plan formé par ladite trappe, au moins une desdites cartes comprenant au moins deux pièces conductrices isolées électriquement l'une de l'autre et reliées chacune à un circuit de détection, un élément conducteur étant fixé au flanc intérieur de la trappe, ledit dispositif étant caractérisé en ce qu'une partie de chacune des pièces conductrices s'étend latéralement au côté de la tranche de ladite carte électronique qui est proximal à la trappe, ledit élément conducteur étant disposé en regard desdites pièces conductrices de sorte à entrer en contact avec icelles lorsque la trappe est placée en position fermée.

Selon un mode de réalisation du dispositif selon l'invention, la partie de chaque pièce conductrice s'étendant latéralement à la tranche de la carte électronique est souple, ladite partie étant une tige, une lamelle ou une languette métallique préformée recourbée en forme de « U », les deux branches du « U » de ladite languette étant sensiblement parallèles à la trappe. Cette configuration permet de faciliter le contact entre l'élément conducteur et les pièces conductrices tout en garantissant une bonne robustesse du dispositif.

Les pièces conductrices peuvent être soudées sur la carte électronique. Par ailleurs, l'élément conducteur fixé sur le flanc intérieur de la trappe peut être un bloc de silicone chargée de particules conductrices. Ce matériau réunit les caractéristiques de souplesse et de conductivité électrique.

Les pièces conductrices peuvent être montées sur un même support maintenant l'isolation électrique entre lesdites pièces, ledit support étant fixé à la carte électronique. Ce mode de réalisation permet de faciliter le montage des deux pièces conductrices en ne nécessitant, par exemple, qu'une seule surface de soudure et/ou en contrôlant plus aisément l'espace entre les deux pièces conductrices.

D'autres caractéristiques apparaîtront à la lecture de la description détaillée donnée à titre d'exemple et non limitative qui suit faite en regard de dessins annexés qui représentent :
- la figure 1, une vue en perspective d'une configuration de l'équipement pour laquelle le dispositif selon l'invention est adapté ;
- la figure 2a, une vue de face d'un premier mode de réalisation du dispositif selon l'invention ;
- la figure 2b, une vue latérale du premier mode de réalisation dispositif selon l'invention ;
- la figure 3, une vue de face d'un deuxième mode de réalisation du dispositif selon l'invention.

Dans un souci de clarté, les mêmes références dans des figures différentes désignent les mêmes éléments.

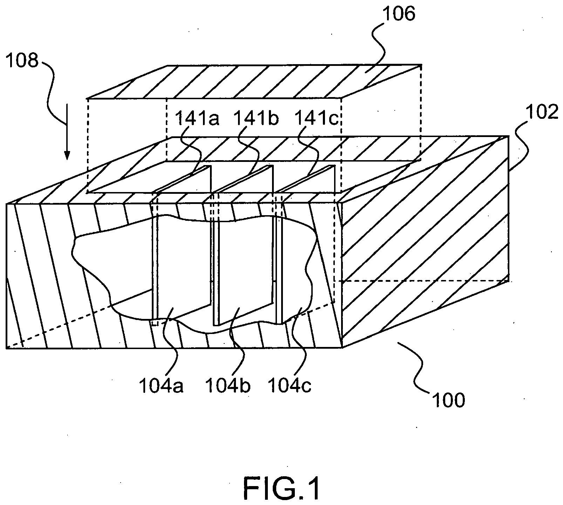

La figure 1 présente une vue en perspective d'une configuration de l'équipement pour laquelle le dispositif selon l'invention est adapté. L'équipement 100 de la figure 1 comprend un boîtier 102 contenant des cartes électroniques 104a, 104b, 104c, et une trappe 106 sous la forme d'une plaque amovible offrant un accès à l'intérieur du boîtier 102. La flèche 108 indique le sens de fermeture de la trappe 106. Selon une autre configuration possible, la trappe 106 est maintenue sur un côté du boîtier par des moyens de fixation, par exemple des charnières.

Les cartes électroniques 104a, 104b, 104c sont inscrites dans des plans respectifs qui sont sensiblement orthogonaux au plan formé par la trappe 106. Autrement dit, pour chaque carte électronique 104a, 104b, 104c, la partie proximale au flanc intérieur de la trappe 106 est un côté 141 a, 141 b, 141c de la tranche de ladite carte 104a, 104b, 104c. En outre, compte tenu du caractère exigu et inextensible des dimensions du boîtier 102 et de la présence de nombreux éléments dans le boîtier 102 (cartes de circuits imprimés espacées seulement des quelques millimètres correspondant à la hauteur des composants électroniques fixés sur celles-ci, composants discrets et fiches de connexion, par exemple), l'espace disponible pour intégrer un dispositif de détection d'ouverture de la trappe 106 est très restreint, par exemple de l'ordre de quelques mm² de surface sur une carte électronique 104a.

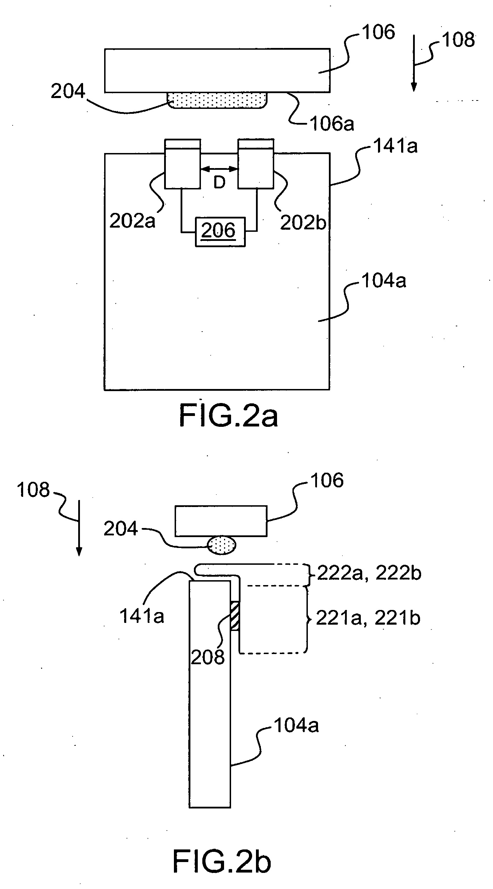

La figure 2a présente une vue de face d'un premier mode de réalisation du dispositif selon l'invention et la figure 2b présente une vue latérale de ce premier mode de réalisation. Le dispositif de l'exemple comprend deux pièces électriquement conductrices 202a, 202b fixées sur une carte électronique 104a, par exemple une carte spécialement dédiée à des fonctions de sécurisation de l'équipement électronique. Le dispositif selon l'invention comprend également un élément électriquement conducteur 204 fixé sur le flanc intérieur 106a de la trappe 106. En outre, chacune des deux pièces 202a, 202b est reliée à un module de traitement 206.

L'élément électriquement conducteur 204 est disposé sur la trappe 106, de sorte que lorsque la trappe 106 est positionnée pour fermer le boîtier de l'équipement, cet élément 204 se trouve plaqué contre les deux pièces conductrices 202a, 202b, établissant alors une liaison électrique entre les deux pièces 202a, 202b et fermant le circuit électrique avec le module de traitement 206.

Le module de traitement 206 est activé par le changement d'état du circuit électrique formé successivement par la première pièce conductrice 202a, l'élément conducteur 204, et la seconde pièce conductrice 202a. Lorsque la trappe 106 est en position fermée, le circuit électrique est à l'état fermé du fait du pont électrique établi entre la première pièce 202a et la seconde pièce 202b. Le module de traitement 206 considère alors cet état comme normal, puisque la trappe 106 doit être fermée pendant le fonctionnement de l'équipement. Lorsque la trappe 106 est ouverte, la liaison électrique est rompue entre les deux pièces conductrices 202a, 202b ; le circuit électrique bascule à l'état « ouvert », ce qui est détecté par le module de traitement 206, lequel peut ensuite lever une alerte ou entraîner une neutralisation de l'équipement, par exemple.

Les deux pièces conductrices 202a, 202b sont isolées électriquement l'une de l'autre en étant, par exemple, espacées d'une courte distance D. A titre d'exemple, les pièces conductrices 202a, 202b ont une largeur d'un millimètre et une longueur totale de quelques millimètres. Chacune des pièces 202a, 202b est, par exemple, une tige, une lamelle ou une languette métallique comportant une première partie 221a, 221 b fixée à la carte électronique 104a et une seconde partie 222a, 222b s'étendant au-delà du côté 141a de la tranche de la carte électronique 104a qui est proximal au flanc intérieur 106a de la trappe 106. La première partie 221a, 221 b de chaque pièce 202a, 202b est, par exemple, soudée 208 sur un flanc de la carte électronique 104a, de préférence au niveau de l'extrémité proche du côté 141a susmentionné de la tranche de la carte 104a. La seconde partie 222a, 222b de chaque pièce 202a, 202b s'étend dans le prolongement de la première partie 221a, 221 b, au-delà de la tranche 141 a. Avantageusement, la forme de la seconde partie 222a, 222b est choisie pour conférer une souplesse à la pièce 202a, 202b, au moins selon un axe orthogonal à la trappe 106. Par exemple, la seconde partie 222a, 222b de la pièce 202a, 202b est préformée en forme de « U », les deux branches du « U » étant parallèles au plan formé par la trappe 106. Ainsi, lorsqu'on ferme la trappe 106, les pièces supportent l'écrasement permanent dû à la pression de l'élément conducteur 204 et le contact entre l'élément 204 et les pièces 202a, 202b est maintenue fermement, évitant tout risque d'ouverture impromptue du circuit électrique de détection.

Avantageusement, l'élément conducteur 204 est constitué d'une matière souple, par exemple de la silicone. Pour conférer des qualités de conducteur électrique à cet élément 204, des particules métalliques peuvent être disséminées dans la silicone. Un tel bloc de silicone chargé de particules constitue une matière à la fois souple et électriquement conductrice, propice à l'utilisation en guise d'élément conducteur 204.

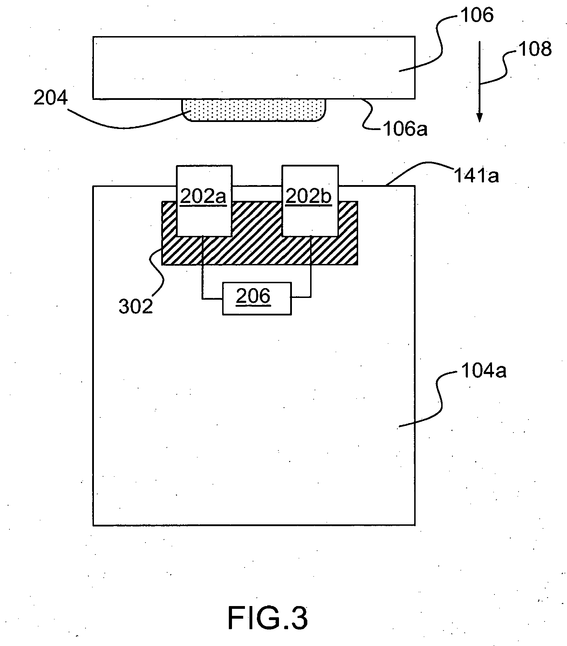

La figure 3 présente une vue de face d'un deuxième mode de réalisation du dispositif selon l'invention. Selon ce deuxième mode de réalisation, les pièces conductrices 202a, 202b sont montées sur un même support 302 qui est fixé sur la carte électronique 104a. Ceci permet de faciliter la fixation desdites pièces sur la carte électronique 104a. En effet, l'espacement des pièces 202a, 202b l'une par rapport à l'autre est maîtrisé plus aisément et une seule surface de soudure est nécessaire pour fixer le support 302 et donc les pièces 202a, 202b sur la carte électronique 104a. Il faut évidemment veiller à ce que le support 302 ne conduise pas le courant électrique entre les deux pièces 202a, 202b ; le choix d'un matériau isolant pour réaliser le support 302 ou l'ajout d'un matériau isolant entre les deux pièces est donc réalisé.

Selon un autre mode de réalisation, le module de traitement 206 est également placé sur le support 302.

Un avantage du dispositif selon l'invention est qu'il est peu encombrant, et donc intégrable dans un espace étriqué. De plus, il ne requiert aucun composant complexe ou fragile (pas de capteur ou de contacteur), ce qui le rend facilement reproductible en série, mais également résistant à des températures élevées et à d'éventuels chocs subis par l'équipement, permettant ainsi, par exemple, de les embarquer dans des véhicules.

## Revendications

1. Equipement comportant un boîtier (102), une trappe (106) fermant le boîtier, une ou plusieurs cartes électroniques (104a, 104b, 104c) dont les plans sont sensiblement orthogonaux au plan formé par la trappe, et un dispositif de détection de l'ouverture de la trappe (106), **caractérisé en ce que** ledit dispositif comprend un circuit de détection (206), un élément conducteur (204), au moins deux pièces conductrices (202a, 202b) isolées électriquement l'une de l'autre, reliées chacune au circuit de détection (206), chaque pièce conductrice (202a, 202b) comportant une partie (222a, 222b) souple s'étendant latéralement au côté (141 a) de la tranche de ladite carte électronique (104a) qui est proximal à la trappe, se présentant sous la forme d'une tige, d'une lamelle ou d'une languette métallique préformée recourbée en forme de « U » ; et dans lequel l'élément conducteur (204) est disposé sur le flanc intérieur de la trappe (106) de telle sorte qu'il rentre en contact avec les pièces conductrices (202a, 202b) lorsque la trappe est fermée.

2. Dispositif de détection selon la revendication 1, **caractérisé en ce que** la partie (222a, 222b) de chaque pièce conductrice (202a, 202b) s'étendant latéralement à la tranche (141a) de la carte électronique (104a) est souple, ladite partie (222a, 222b) étant une tige, une lamelle ou une languette métallique préformée recourbée en forme de « U », les deux branches du « U » de ladite languette étant sensiblement parallèles à la trappe.

3. Dispositif de détection selon l'une quelconque des revendications précédentes, **caractérisé en ce que** les pièces conductrices (202a, 202b) sont soudées sur la carte électronique (104a).

4. Dispositif de détection selon l'une quelconque des revendications précédentes, **caractérisé en ce que** l'élément conducteur (204) fixé sur le flanc intérieur de la trappe (106) est un bloc de silicone chargée de particules conductrices.

5. Dispositif de détection selon l'une quelconque des revendications précédentes, **caractérisé en ce que** les pièces conductrices (202a, 202b) sont montées sur un même support maintenant l'isolation électrique entre lesdites pièces (202a, 202b), ledit support étant fixé à la carte électronique (104a).

## Patentansprüche

1. Anlage, die Folgendes umfasst: ein Gehäuse (102), einen Abschlussdeckel (106), der das Gehäuse verschließt, eine oder mehrere elektronische Karten (104a, 104b, 104c), deren Ebenen im Wesentlichen orthogonal zu der durch den Abschlussdeckel gebildeten Ebene sind, und eine Vorrichtung zum Erkennen der Öffnung des Abschlussdeckels (106), **dadurch gekennzeichnet, dass** die Vorrichtung einen Erkennungsschaltkreis (206), ein Leiterelement (204), wenigstens zwei elektrisch voneinander isolierte leitende Stücke (202a, 202b) umfasst, die jeweils mit dem Erkennungsschaltkreis (206) verbunden sind, wobei jedes leitende Stück (202a, 202b) einen elastischen Teil (222a, 222b) umfasst, der lateral zur Seite (141a) des Wafers der elektronischen Karte (104a) verläuft, die proximal zu dem Abschlussdeckel ist, in Form eines/r metallischen Stabs, Lamelle oder Zunge, der/die U-förmig gekrümmt vorgeformt ist; und wobei das Leiterelement (204) an der inneren Flanke des Abschlussdeckels (106) angeordnet ist, so dass es mit den leitenden Stücken (202a, 202b) in Kontakt kommt, wenn der Abschlussdeckel geschlossen wird.

2. Erkennungsvorrichtung nach Anspruch 1, **dadurch gekennzeichnet, dass** der Teil (222a, 222b) jedes leitenden Stücks (202a, 202b), der lateral zu dem Wafer (141a) der elektronischen Karte (104a) verläuft, elastisch ist, wobei der Teil (222a, 222b) ein(e) metallische(r) Stab, Lamelle oder Zunge ist, der/die U-förmig gekrümmt vorgeformt ist, wobei die beiden Zweige des "U" der Zunge im Wesentlichen parallel zu dem Abschlussdeckel sind.

3. Erkennungsvorrichtung nach einem der vorherigen Ansprüche, **dadurch gekennzeichnet, dass** die leitenden Stücke (202a, 202b) auf die elektronische Karte (104a) gelötet sind.

4. Erkennungsvorrichtung nach einem der vorherigen Ansprüche, **dadurch gekennzeichnet, dass** das auf der inneren Flanke des Abschlussdeckels (106) befestigte Leiterelement (204) ein mit leitenden Partikeln beladener Silikonblock ist.

5. Erkennungsvorrichtung nach einem der vorherigen Ansprüche, **dadurch gekennzeichnet, dass** die leitenden Stücke (202a, 202b) auf einem selben Stützteil montiert sind, das die elektrische Isolation zwischen den Stücken (202a, 202b) aufrechterhält, wobei das Stützteil an der elektronischen Karte (104a) befestigt ist.

## Claims

1. Equipment comprising a housing (102), a hatch (106) that closes the housing, one or more electronic boards (104a, 104b, 104c) the planes of which are substantially orthogonal to the plane formed by the hatch, and a device for detecting opening of the hatch (106), **characterised in that** said device comprises a detection circuit (206), a conductive element (204), at least two conductive pieces (202a, 202b) that are electrically isolated from one another, each connected to the detection circuit (206), each conductive piece (202a, 202b) comprising a flexible part (222a, 222b) that extends laterally to the side (141a) of the edge of said electronic board (104a) which is proximal to the hatch, being in the form of a pre-moulded metal rod, strip or tab bent in a "U" shape; and in which the conductive element (204) is disposed on the inner flank of the hatch (106) such that it comes into contact with the conductive pieces (202a, 202b) when the hatch is closed.

2. The detection device according to Claim 1, **characterised in that** the part (222a, 222b) of each conductive piece (202a, 202b) that extends laterally to the edge (141a) of the electronic board (140a) is flexible, said part (222a, 222b) being a pre-moulded metal rod, strip or tab bent in "U" shape, the two branches of the "U" of said tab being substantially parallel to the hatch.

3. The detection device according to any of the preceding claims, **characterised in that** the conductive pieces (202a, 202b) are welded onto the electronic board (104a).

4. The detection device according to any of the preceding claims, **characterised in that** the conductive element (204) fixed to the inner flank of the hatch (106) is a block of silicon loaded with conductive particles.

5. The detection device according to any of the preceding claims, **characterised in that** the conductive pieces (202a, 202b) are mounted on the same support that maintains the electrical isolation between said pieces (202a, 202b), said support being fixed to the electronic board (104a).
